# EUROPEAN PATENT APPLICATION

(11) **EP 4 369 879 A1**
(43) Date of publication of application: **15.05.2024**
(21) Application number: 23193189.0
(22) Date of filing: 24.08.2023
(51) Int. Cl.: H05K 7/20

(54) **HEAT EXCHANGE STRUCTURE OF POWER ELECTRONIC APPARATUS, HEAT DISSIPATION AIR PASSAGE AND POWER ELECTRONIC APPARATUS**

(30) Priority: 11.11.2022 CN 202223014897 U
(71) Applicant: Sungrow Power Supply Co., Ltd., Hefei, Anhui 230088 (CN)
(72) Inventor: Lu, Zheng, Hefei, 230088 (CN); Liu, Long, Hefei, 230088 (CN); Li, Yonghong, Hefei, 230088 (CN); Zhu, Qiyao, Hefei, 230088 (CN)
(74) Representative: Epping - Hermann - Fischer

(57) **Abstract**

A heat exchange structure of a power electronic apparatus, a heat dissipation air passage and a power electronic apparatus are provided. The heat exchange structure of a power electronic apparatus includes a case and at least one heat exchanger. A first cavity and a second cavity are arranged in the case. The first cavity is configured to accommodate a heating device, and the first cavity is a closed cavity. The at least one heat exchanger is arranged in the first cavity, and has a heat exchange air passage communicated with the second cavity. In the heat exchange structure of a power electronic apparatus, by arranging a heat exchange air passage in the heat exchanger, a heat exchange area is increased compared to a heat exchange plate in the conventional technology. Moreover, the heat exchanger is arranged in the first cavity, the heat exchange air passage is in communication with the second cavity, and thus the heat exchanger is designed in an embedded manner. Compared to the heat exchange plate in the conventional technology, the heat exchange air passage has a greater length, further increasing the heat exchange area. Therefore, the heat exchange area is increased effectively with the heat exchange structure of a power electronic apparatus, thereby improving heat dissipation capacity and heat dissipation effect.

## Description

### FIELD

The present application relates to the technical field of heat dissipation of power electronic apparatuses, and in particular to a heat exchange structure of a power electronic apparatus, a heat dissipation air passage and a power electronic apparatus.

### BACKGROUND

In a power electronic apparatus, power semiconductor devices, magnetic devices, capacitors and other heating devices generate a large amount of heat, and the heat is required to be dissipated to ensure normal operation of the power electronic apparatus.

At present, air cooling heat dissipation is mainly used. Specifically, a first cavity and a second cavity that are not in communication with each other are arranged in a case of the power electronic apparatus. Heating devices are arranged in the first cavity. The first cavity and the second cavity exchange heat through a heat exchange plate, that is, one side of the heat exchange plate exchanges heat with a hot air flow in the first cavity, and the other side of the heat exchange plate exchanges heat with a cold air flow in the second cavity, thereby realizing heat dissipation of the heating devices in the first cavity.

The heat exchange area in the above heat dissipation method is small, which results in poor heat dissipation capacity and heat dissipation effect of the heat dissipation method, so that it is difficult for the heat dissipation method to meet requirements of a power electronic apparatus with a high power density and a high heat flux.

Therefore, how to design heat dissipation for the power electronic apparatus to improve heat dissipation capacity and heat dissipation effect has attracted the attention of those skilled in the art.

### SUMMARY

In view of this, an object of the present application is to provide a heat exchange structure of a power electronic apparatus, a heat dissipation air passage and a power electronic apparatus, to improve heat dissipation capacity and heat dissipation effect.

In order to achieve the above object, the following technical solutions are provided according to the present application.

A heat exchange structure of a power electronic apparatus includes:
a case; and
at least one heat exchanger; where
a first cavity and a second cavity are arranged in the case, the first cavity is configured to accommodate a heating device, and the first cavity is a closed cavity; and
the at least one heat exchanger is arranged in the first cavity, and the at least one heat exchanger has a heat exchange air passage communicated with the second cavity.

In an embodiment, a first air cooling heat exchange structure and/or a liquid cooling heat exchange structure are provided in the heat exchange air passage.

In an embodiment, the first air cooling heat exchange structure includes a heat exchange fin or an air cooling heat exchange tube, and the liquid cooling heat exchange structure includes a liquid cooling heat exchange tube or a liquid cooling heat exchange plate.

In an embodiment, a second air cooling heat exchange structure is provided on an outer surface of the at least one heat exchanger.

In an embodiment, the at least one heat exchanger includes: a heat exchange housing, and connection ports communicated with two ends of the heat exchange housing respectively, and
the heat exchange air passage is formed by an inner cavity of each of the connection ports and an inner cavity of the heat exchange housing.

In an embodiment, each of the connection ports has a first interface and a second interface;
the first interface is in communication with the inner cavity of the heat exchange housing, and the second interface is in communication with the second cavity; and
an axis of the first interface is perpendicular to or inclined relative to an axis of the second interface, and a length direction of the heat exchange housing is parallel to the axis of the first interface.

In an embodiment, a first air cooling heat exchange structure is provided in the heat exchange housing and/or at least one of the connection ports; or, a liquid cooling heat exchange structure is provided in the heat exchange housing and/or at least one of the connection ports.

In an embodiment, the first cavity includes an inner mounting wall for arranging the heating device, and the at least one heat exchanger is arranged on the inner mounting wall.

In an embodiment, the at least one heat exchanger is arranged close to an edge of the first cavity.

In an embodiment, the heat exchange structure of a power electronic apparatus further includes: at least one first fan, and/or at least one second fan;
the at least one first fan is arranged in the first cavity, and the at least one second fan is arranged in the second cavity.

In the heat exchange structure of a power electronic apparatus according to the present application, a hot air flow in the first cavity transfers heat to the heat exchanger, and a cold air flow in the second cavity cools the heat exchanger during a process of passing through the heat exchange air passage, thereby realizing cooling of the air flow in the first cavity, that is, realizing cooling of the heating device in the first cavity.

In the heat exchange structure of a power electronic apparatus according to the present application, the heat exchange air passage is arranged in the heat exchanger, which increases the heat exchange area compared to a heat exchange plate in the conventional technology. Moreover, the heat exchanger is arranged in the first cavity, and the heat exchange air passage is in communication with the second cavity, and thus the heat exchanger is designed in an embedded manner. Compared with the heat exchange plate in the conventional technology, the length of the heat exchange air passage is greater, further increasing the heat exchange area. Therefore, the heat exchange area is increased effectively with the heat exchange structure of a power electronic apparatus, thereby improving heat dissipation capacity and heat dissipation effect.

Based on the above heat exchange structure of a power electronic apparatus, a power electronic apparatus is further provided according to the present application. The power electronic apparatus includes a heating device and the heat exchange structure of a power electronic apparatus according to any one of the above embodiments.

A heat dissipation air passage, applied to a power electronic apparatus, includes:
an inner cavity for an air flow in a second cavity of a case to flow through; and
an outer surface for an air flow in a first cavity of the case to flow through; where
the first cavity is a closed cavity and is configured to accommodate a heating device.

In an embodiment, a first air cooling heat exchange structure and/or a liquid cooling heat exchange structure are provided in the inner cavity of the heat dissipation air passage.

In an embodiment, a second air cooling heat exchange structure is provided on the outer surface of the heat dissipation air passage.

Based on the above heat dissipation air passage, a power electronic apparatus is further provided according to the present application. The power electronic apparatus includes a heating device, a case having a first cavity and a second cavity, and the heat dissipation air passage according to any one of the above embodiments.

### BRIEF DESCRIPTION OF THE DRAWINGS

In order to more clearly illustrate technical solutions in embodiments of the present application or in the conventional technology, accompanying drawings used in the description of the embodiments or the conventional technology are briefly introduced below. Apparently, the accompanying drawings in the following description only illustrates the embodiments of the present application. Other drawings may further be obtained by those skilled in the art, based on the provided drawings without creative efforts.
FIG 1 is an isometric view of a heat exchange structure of a power electronic apparatus according to a first embodiment of the present application;
FIG 2 is an isometric view of the heat exchange structure of a power electronic apparatus shown in FIG 1 viewed in another direction;
FIG 3a is a side view of the heat exchange structure of a power electronic apparatus shown in FIG 1 and a schematic diagram of an airflow circulation in a second cavity and a heat exchanger;
FIG 3b is a top view of the heat exchange structure of a power electronic apparatus shown in FIG 1 and a schematic diagram of an airflow circulation in a first cavity;
FIG 3c is a front view of the heat exchange structure of a power electronic apparatus shown in FIG 1 and a schematic diagram of an airflow circulation in the first cavity;
FIG 4 is an exploded view of a heat exchanger in the heat exchange structure of a power electronic apparatus according to the first embodiment of the present application;
FIG 5a is a side view of a heat exchange structure of a power electronic apparatus according to a second embodiment of the present application, and a schematic diagram of an airflow circulation in a second cavity and a heat exchanger;
FIG 5b is a top view of the heat exchange structure of a power electronic apparatus according to the second embodiment of the present application, and a schematic diagram of an airflow circulation in a first cavity;
FIG 5c is a front view of the heat exchange structure of a power electronic apparatus according to the second embodiment of the present application, and a schematic diagram of an airflow circulation in the first cavity;
FIG 6 is an isometric view of a heat exchange structure of a power electronic apparatus according to a third embodiment of the present application;
FIG 7 is an isometric view of the heat exchange structure of a power electronic apparatus shown in FIG 6 viewed in another direction;
FIG 8 is an isometric view of a heat exchanger in the heat exchange structure of a power electronic apparatus shown in FIG 6;
FIG 9 is an exploded view of the heat exchanger shown in FIG 8;
FIG 10 is an isometric view of a heat exchange structure of a power electronic apparatus according to a fourth embodiment of the present application;
FIG 11 is an isometric view of the heat exchange structure of a power electronic apparatus shown in FIG 10 viewed in another direction;
FIG 12 is an isometric view of a heat dissipation air passage according to a sixth embodiment of the present application; and
FIG 13 is an isometric view of the heat dissipation air passage according to the sixth embodiment of the present application viewed in another direction.

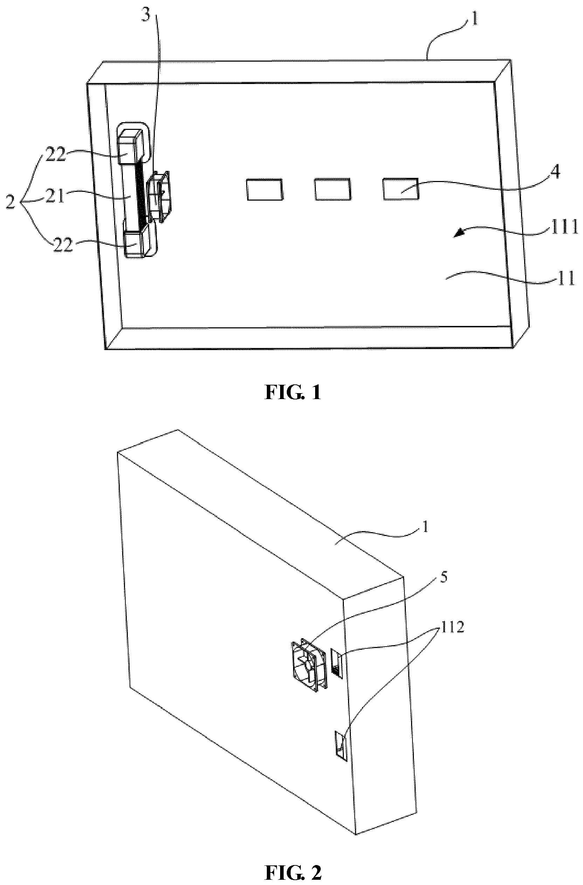

Reference numerals in FIGS. 1 to 13 are listed as follows:

| | | | |
|---|---|---|---|
| 1. | case; | 2. | heat exchanger; |
| 2a. | heat dissipation air passage; | 3. | first fan; |
| 4. | heating device; | 5. | second fan; |
| 11. | first cavity; | 12. | second cavity; |
| 111. | inner mounting wall; | 112. | communication port; |
| 21. | heat exchange housing; | 22. | connection port; |
| 23. | heat exchange fin; | 24. | heat exchange groove |
| 25. | outer surface; | 26. | inner cavity. |

### DETAILED DESCRIPTION OF THE EMBODIMENTS

The technical solutions in the embodiments of the present application are clearly and completely described below in conjunction with the accompanying drawings. Apparently, the described embodiments are only a part of the embodiments of the present application, not all of them. Based on the embodiments in the present application, other embodiments obtained by those skilled in the art without creative efforts fall within the protection scope of the present application.

In order to improve heat dissipation capacity and heat dissipation effect of a power electronic apparatus, a heat exchange structure of a power electronic apparatus is provided according to the present application. The heat change structure is specifically described hereinafter in four embodiments.

### First embodiment

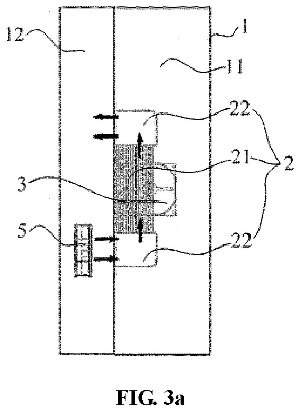

As shown in FIGS. 1 to 3c, a heat exchange structure of a power electronic apparatus according to the first embodiment includes a case 1 and a heat exchanger 2.

A high protection level (IP protection level) is generally required for electronic devices of a power electronic apparatus. In order to meet requirements of the electronic devices, the case 1 generally has a first cavity 11 and a second cavity 12.

The first cavity 11 is configured to accommodate a heating device 4. It can be understood that the heating device 4 is an electronic device, for example, at least one heating device 4 is a power semiconductor device, and/or at least one heating device 4 is a magnetic device, and/or at least one heating device 4 is a capacitor, and so on. Other electronic devices may further be arranged in the first cavity 11. In order to protect the heating device 4 and other electronic devices, the first cavity 11 is a closed cavity. It can be understood that the first cavity 11 and the second cavity 12 are not in communication with each other.

The protection level of the first cavity 11 is relatively high to ensure requirements of the normal operation of electronic devices such as the heating device 4. For example, the first cavity 11 has a protection level of IP65.

No electronic device is arranged in the second cavity 12, or electronic devices with lower requirements of protection level are arranged in the second cavity 12. The protection level of the second cavity 12 may be high or low. Usually, the protection level of the first cavity 11 is not lower than the protection level of the second cavity 12.

In some embodiments, the protection level of the first cavity 11 is higher than that of the second cavity 12. In this case, an inner cavity of the case 1 may be divided into the first cavity 11 and the second cavity 12 based on the protection level.

Thermal conductive potting adhesive may be arranged in the second cavity 12, and the heat within the first cavity 11 can be dissipated to the second cavity 12 through an outer wall of the first cavity 11.

The first cavity 11 and the second cavity 12 may be arranged side by side or in other manners, for example, the second cavity 12 surrounds or semi-surrounds the first cavity 11. The relative position of the first cavity 11 and the second cavity 12 is selected according to actual operation, which is not limited in the embodiment.

The heat exchanger 2 is arranged in the first cavity 11, and has a heat exchange air passage communicated with the second cavity 12.

In order to facilitate the communication between the heat exchange air passage and the second cavity 12, the first cavity 11 is provided with two communication ports 112, and each of two ends of the heat exchange air passage is in communication with the second cavity 12 through a corresponding communication port 112. In this case, it can be understood that the heat exchanger 2 is a part of the first cavity 11 to ensure that the first cavity 11 is a closed cavity.

It should be noted that the heat exchanger 2 can exchange heat with an air flow in the first cavity 11, and an air flow in the second cavity 12 can exchange heat with the heat exchanger 2 when passing through the heat exchange air passage.

It should be noted that, a plate of the first cavity 11 and the second cavity 12 are hidden in FIG 1; and the second cavity 12 is hidden in FIG 2.

Since a heat dissipation space is reserved in the first cavity 11, in the arrangement of the heat exchanger 2 in the first cavity 11, the heat exchanger 2 may be arranged in the reserved heat dissipation space in the first cavity 11, which avoids the occupation of the space in the second cavity 12 by the heat exchanger 2 and avoids increasing the volume of the second cavity 12, thereby avoiding increasing the volume of the entire case 1, that is, not affecting the external dimensions of the case 1.

The number of the heat exchanger 2 may be one, two or more, and the number of the heat exchanger 2 is selected according to actual needs, which is not limited in the first embodiment.

In the above heat exchange structure of a power electronic apparatus, the heat exchanger 2 is arranged in the first cavity 11, and the heat exchange air passage of the heat exchanger 2 is in communication with the second cavity 12. In this way, a hot air flow in the first cavity 11 transfers a high temperature to the heat exchanger 2, and a cold air flow in the second cavity 12 cools the heat exchanger when passing through the heat exchange air passage, thereby realizing the cooling of the air flow in the first cavity 11, that is, the cooling of the heating device 4 in the first cavity 11.

In the above heat exchange structure of a power electronic apparatus, by arranging a heat exchange air passage in the heat exchanger 2, the heat exchange area is increased compared to the heat exchange plate in the conventional technology. Moreover, the heat exchanger 2 is arranged in the first cavity 11, the heat exchange air passage is in communication with the second cavity 12, and thus the heat exchanger 2 is designed in an embedded manner. Compared to the heat exchange plate in the conventional technology, a length of the heat exchange air passage is greater, further increasing the heat exchange area. Therefore, the heat exchange area is increased effectively with the heat exchange structure of the power electronic apparatus, thereby improving heat dissipation capacity and heat dissipation effect.

It should be noted that under a same volume of the case 1, the heat exchange structure of a power electronic apparatus according to the embodiment can be applied to a power electronic apparatus with a high power level, a high power density, and a high heat flux, which is conducive to efficient heat dissipation and compact structure. Of course, the heat exchange structure of a power electronic apparatus according to the embodiment can also be applied to a power electronic apparatus with a low power level, a low power density, and a low heat flux. The application of the heat exchange structure of a power electronic apparatus is not limited in the embodiment.

Since the heat dissipation capability and the heat dissipation effect are improved with the heat exchange structure of a power electronic apparatus according to the embodiment, the heat exchange structure can be applied to a situation with a high ambient temperature. Specifically, in a case of a high ambient temperature, the above heat exchange structure of a power electronic apparatus can also solve the problem of damages to the power electronic apparatus or a power reduction of the power electronic apparatus caused by excessive heat in the first cavity 11. The above heat exchange structure of a power electronic apparatus can ensure the normal operation of the power electronic apparatus at a high ambient temperature.

In some embodiments, in order to improve heat dissipation capacity, a first air cooling heat exchange structure and/or a liquid cooling heat exchange structure are arranged in the heat exchange air passage.

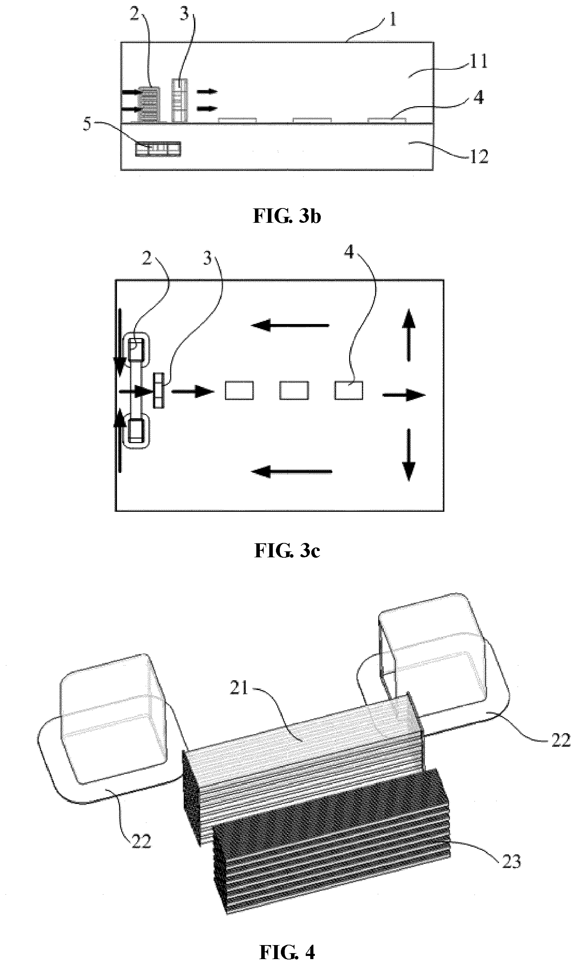

In some embodiments, as shown in FIG 4, the first air cooling heat exchange structure includes a heat exchange fin 23. Usually, the number of the heat exchange fin 23 is plural, and the air flow flows through a gap between two adjacent ones of the heat exchange fins 23.

The number and the type of the heat exchange fins 23 are selected according to actual needs, which are not limited in the embodiment.

In some embodiments, the first air cooling heat exchange structure includes an air cooling heat exchange tube. The number and the distribution of the air cooling heat exchange tube are selected according to actual needs, which are not limited in the embodiment.

Of course, alternatively, the first air cooling heat exchange structure may include a heat exchange fin 23 and an air cooling heat exchange tube. The specific form of the first air cooling heat exchange structure is not limited in the embodiment.

In some embodiments, the liquid cooling heat exchange structure includes a liquid cooling heat exchange tube and/or a liquid cooling heat exchange plate. The specific structure, number and distribution of the liquid cooling heat exchange tube, as well as the specific structure, number and distribution of the liquid cooling heat exchange plate, are selected according to actual needs, which are not limited in the embodiment.

The heat exchanger 2 may be of multiple structures. In order to facilitate the embedded design of the heat exchanger 2, as shown in FIG 1, the heat exchanger 2 includes: a heat exchange housing 21, and connection ports 22 communicated with two ends of the heat exchange housing 21 respectively; an inner cavity of each of the connection ports 22 and an inner cavity of the heat exchange housing 21 form the heat exchange air passage; the connection ports 22 are arranged on an inner wall of the first cavity 11, and the connection ports 22 are in communication with the second cavity 12.

Each of the connection port 22 includes a first interface and a second interface; the first interface is in communication with an inner cavity of the heat exchange housing, and the second interface is in communication with the second cavity 12.

An axis of the first interface may be parallel to, perpendicular to, or inclined relative to an axis of the second interface. In order to reduce the volume of the heat exchanger 2, the axis of the first interface is perpendicular to or inclined relative to the axis of the second interface, and a length direction of the heat exchange housing is parallel to the axis of the first interface.

In a case of using the heat exchanger 2, on the one hand, a first air cooling heat exchange structure is arranged in the heat exchange housing 21 and/or at least one connection port 22. In some embodiments, the first air cooling heat exchange structure includes a heat exchange fin 23. As shown in FIG 4, the heat exchange fin 23 is arranged in the heat exchange housing 21.

On the other hand, alternatively, a liquid cooling heat exchange structure may be arranged in the heat exchange housing 21 and/or at least one connection port 22.

For the first air cooling heat exchange structure and the liquid cooling heat exchange structure, reference may be made to the above description, and details are not be repeated here.

In some embodiments, the heat exchanger 2 may be of other structures, and is not limited to the aforementioned structures.

In some embodiments, the first cavity 11 includes an inner mounting wall 111 for arranging the heating device 4, and the heat exchanger 2 is arranged on the inner mounting wall 111. It can be understood that in order to facilitate heat dissipation, there is a gap between an inner wall of the first cavity 11 except for the inner mounting wall 111 and the heat exchanger 2. Of course, the heat exchanger 2 may be arranged in other positions, which is not limited in the embodiment.

In order to reduce the influence of the heat exchanger 2 on other devices in the first cavity 11, the heat exchanger 2 is close to an edge of the first cavity 11. As shown in FIG 3b, the heat exchanger 2 is arranged at one end of the first cavity 11 in a length direction. Correspondingly, a first fan 3 is arranged at one end of the first cavity 11 in the length direction, and a second fan 5 is arranged at one end of the second cavity 12 in a length direction. It can be understood that the length direction of the first cavity 11 is the length direction of the case 1, and the length direction of the second cavity 12 is the length direction of the case 1.

Of course, the heat exchanger 2 may also be arranged in other positions, which is not limited to the above structures.

As shown in FIG 1, in order to accelerate the flow of air in the first cavity 11, the heat exchange structure of a power electronic apparatus further includes at least one first fan 3, and the at least one first fan 3 is arranged in the first cavity 11.

The type, the number and the position of the first fan 3, and the relative position of the first fan 3 and the heat exchanger 2 are selected according to actual needs, which are not limited in the embodiment.

As shown in FIG 2, in order to accelerate the flow of air in the second cavity 12, the above heat exchange structure of a power electronic apparatus further includes at least one second fan 5, and the at least one second fan 5 is arranged in the second cavity 12.

The type, the number and the position of the second fan 5, and the relative position of the second fan 5 and the heat exchanger 2 are selected according to actual needs, which are not limited in the embodiment.

As shown in FIGS. 3a and 3b, in order to effectively improve the heat exchange efficiency, the above heat exchange structure of a power electronic apparatus may include a first fan 3 and a second fan 5.

As shown in FIG 3a, the heat exchanger 2 is arranged at an air outlet end of the second fan 5. Under the action of the second fan 5, the cold air flow in the second cavity 12 enters the heat exchange air passage from an inlet of the heat exchange air passage, and the cold air flow passes through the heat exchange air passage and is discharged through an outlet of the heat exchange air passage. As shown in FIGS. 3b and 3c, the heat exchanger 2 is arranged at an air inlet end of the first fan 3, and the first fan 3 is arranged between the heat exchanger 2 and the heating device 4. Under the action of the first fan 3, the cold air flow in the first cavity 11 flows through the outside of the heat exchanger 2.

### Second embodiment

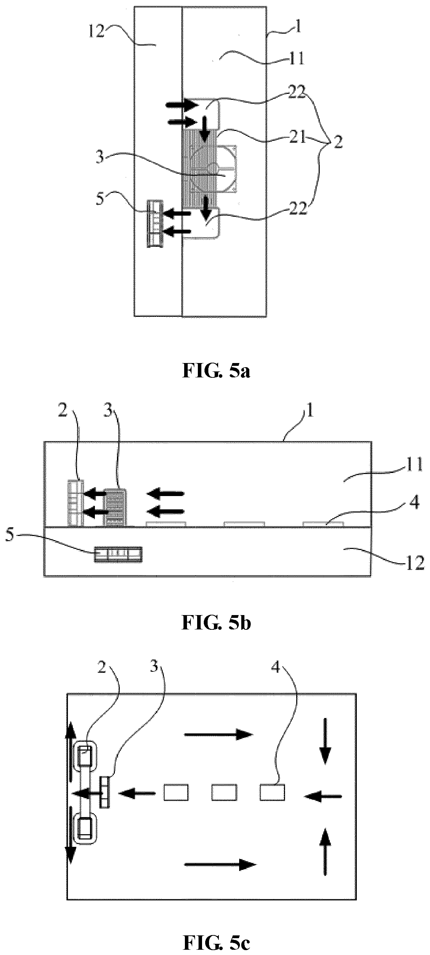

As shown in FIGS. 5a to 5c, the main difference between a heat exchange structure of a power electronic apparatus according to the second embodiment and the heat exchange structure of a power electronic apparatus according to the first embodiment is that: the heat exchanger 2 is arranged at an air outlet end of the first fan 3 and at an air inlet end of the second fan 5.

In the second embodiment, reference may be made to the first embodiment for the specific structure of the heat exchange structure of a power electronic apparatus, which is not repeated here.

### Third embodiment

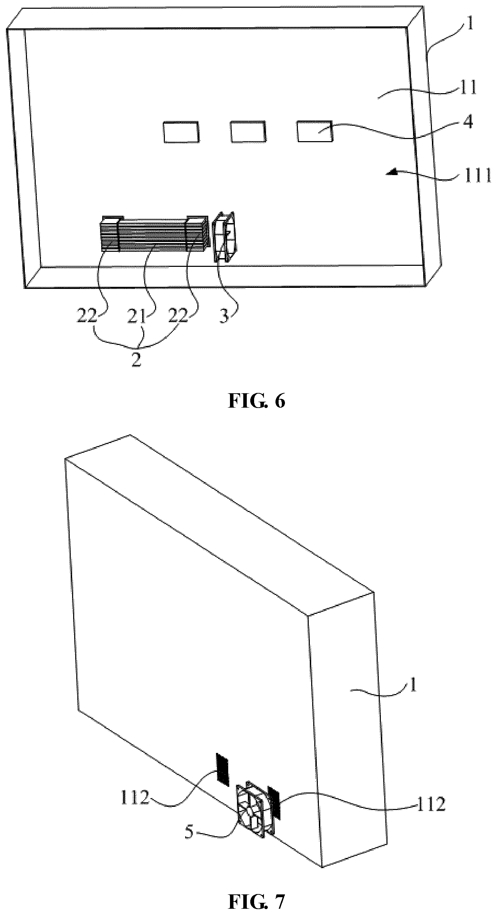

As shown in FIGS. 6 and 7, the difference between a heat exchange structure of a power electronic apparatus according to the third embodiment and the heat exchange structure of a power electronic apparatus according to the first embodiment mainly lies in the specific positions of the heat exchanger 2, the first fan 3 and the second fan 5. Specifically, the heat exchanger 2 and the first fan 3 are arranged at one end of the first cavity 11 in a width direction. Correspondingly, the second fan 5 is arranged at one end of the second cavity 12 in a width direction. It can be understood that the width direction of the first cavity 11 is the width direction of the case 1, and the width direction of the second cavity 12 is the width direction of the case 1.

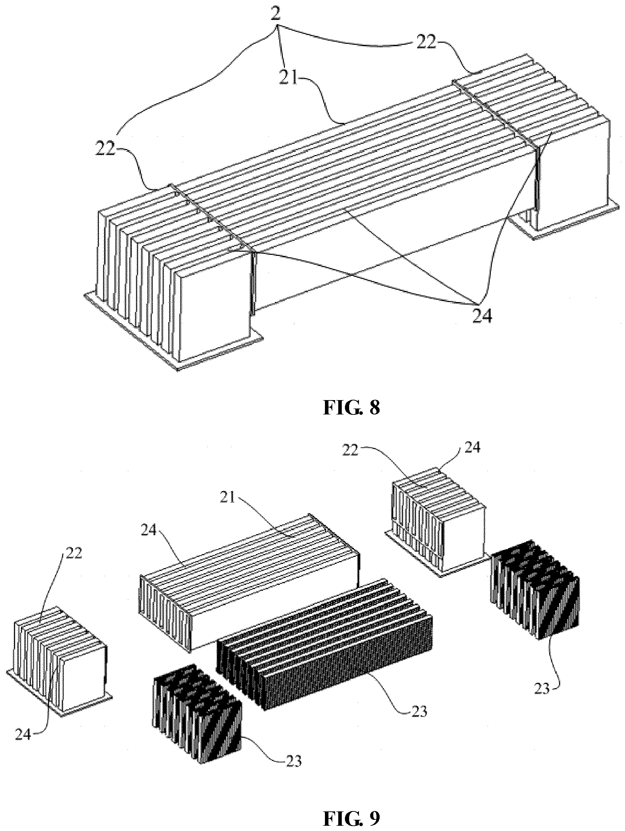

As shown in FIGS. 8 and 9, in order to improve the heat dissipation capacity, the outer surface of the heat exchanger 2 is provided with heat exchange grooves 24. Specifically, the heat exchange grooves 24 are arranged on an outer surface of the heat exchange housing 21 and an outer surface of each of the two connection ports 22. In this way, an area of the outer surface of the heat exchanger 2 is increased, which increases the heat exchange area between the hot air in the first cavity 11 and the heat exchanger 2, thereby improving the heat dissipation capacity and the heat dissipation effect.

The number and the type of the heat exchange grooves 24 are selected according to actual needs, which are not limited in the embodiment.

In some embodiments, the outer surface of the heat exchanger 2 may be provided with other air cooling heat exchange structures, such as heat exchange protrusions, except for the heat exchange grooves 24, which is not limited in the third embodiment.

As shown in FIGS. 9, in order to improve the heat dissipation capacity, the heat exchange fins 23 are arranged in the heat exchange housing 21 and two connection ports 22.

The number and the type of the heat exchange fins 23 are selected according to actual needs, which are not limited in the embodiment.

Reference may be made to the first embodiment for other structures of the heat exchange structure of a power electronic apparatus in the third embodiment, which is not repeated here.

### Fourth embodiment

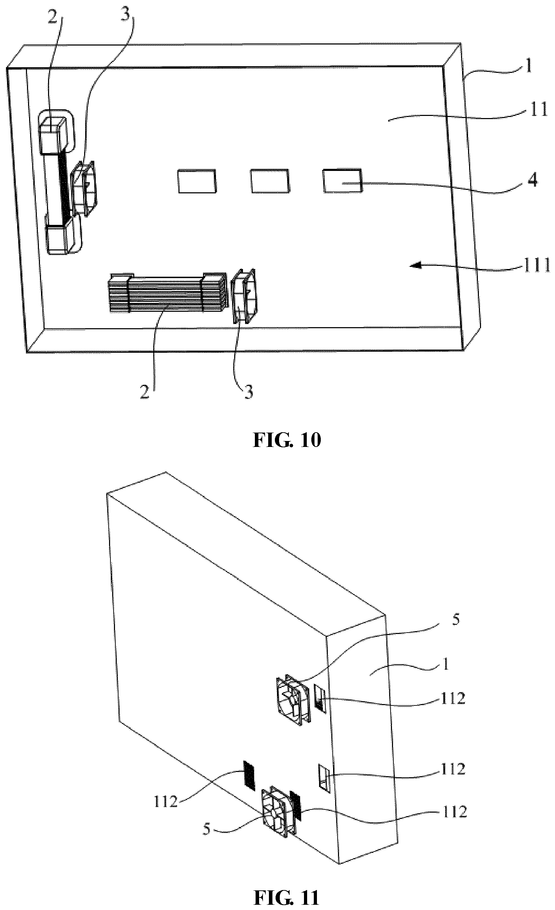

As shown in FIGS. 10 and 11, the main difference between a heat exchange structure of a power electronic apparatus according to the fourth embodiment and the heat exchange structure of a power electronic apparatus according to the first embodiment is that the numbers of the heat exchanger 2, the first fan 3, and the second fan 5 each is two.

It can be understood that the heat exchange structure of a power electronic apparatus according to the fourth embodiment is a combined structure of the heat exchange structures according to the first embodiment and the third embodiment.

In some embodiments, the number of the heat exchanger 2 may be three or more, and the first fans 3 and second fans 5 are in one-to-one correspondence with the three or more heat exchangers 2.

Reference may be made to the first and the third embodiments for other structures of the heat exchange structure of a power electronic apparatus in the fourth embodiment, which are not repeated here.

### Fifth embodiment

Based on the heat exchange structures of a power electronic apparatus described in the above four embodiments, a power electronic apparatus is further provided according to the fifth embodiment. The power electronic apparatus includes a heating device and the heat exchange structure of a power electronic apparatus according to the above embodiments.

Since the heat exchange structure of a power electronic apparatus according to the above embodiments has the above technical effects, and the power electronic apparatus according to the embodiment includes the above heat exchange structure of a power electronic apparatus, the power electronic apparatus according to the embodiment also has corresponding technical effects, which are not repeated here.

The power electronic apparatus may be a power converter or other apparatuses, which is not limited in the embodiment.

In order to improve the heat dissipation capacity and the heat dissipation effect of the power electronic apparatus, a heat dissipation air passage applied to a power electronic apparatus is further provided by the present application. The heat dissipation air passage is specifically described based on a sixth embodiment.

### Sixth embodiment

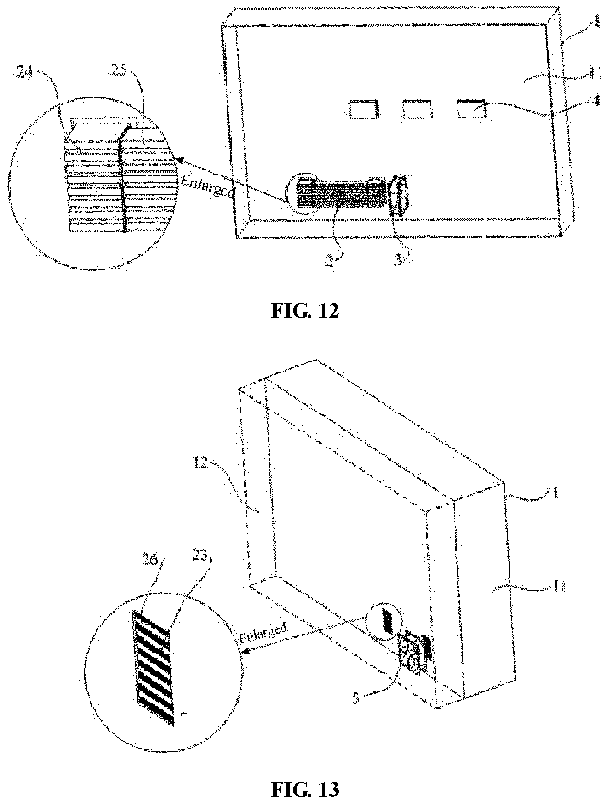

A heat dissipation air passage according to the sixth embodiment is applied to a power electronic apparatus. As shown in FIGS. 12 and 13, a heat dissipation air passage 2a includes an inner cavity 26 for an air flow in a second cavity 12 of a case 1 to flow through, and an outer surface 25 for an air flow in a first cavity 11 of a case 1 to flow through. The first cavity 11 is a closed cavity and is configured to accommodate a heating device 4.

Reference may be made to the first embodiment for the distribution and protection levels of the first cavity 11 and the second cavity 12, which is not repeated here.

It can be understood that the heat dissipation air passage 2a is arranged in the first cavity 11 to ensure that the outer surface 25 of the heat dissipation air passage 2a is provided for the air flow in the first cavity 11 of the case 1 to flow through. The inner cavity 26 of the heat dissipation air passage 2a is configured to communicate with the second cavity 12 to ensure that the inner cavity 26 is provided for the air flow in the second cavity 12 of the case 1 to flow through. The outer surface 25 of the heat dissipation air passage 2a can exchange heat with the air flow in the first cavity 11, and the inner cavity 26 of the heat dissipation air passage 2a can exchange heat with the air flow in the second cavity 12.

It should be noted that a plate of the first cavity 11 and the second cavity 12 are hidden in FIG 12; and in order to show the structure of the heat dissipation air passage 2a, the second cavity 12 is indicated by dotted lines in FIG 13.

Since a heat dissipation space is reserved in the first cavity 11, in the arrangement of the heat dissipation air passage 2a in the first cavity 11, the heat dissipation air passage 2a may be arranged in the reserved heat dissipation space in the first cavity 11, which avoids the occupation of the space in the second cavity 12 by the heat dissipation air passage 2a and avoids increasing the volume of the second cavity 12, thereby avoiding increasing the volume of the entire case 1, that is, not affecting the external dimensions of the case 1.

The number of the heat dissipation air passage 2a may be one, two or more, and the number of the heat dissipation air passage 2a is selected according to actual needs, which is not limited in the sixth embodiment.

In the power electronic apparatus with the heat dissipation air passage 2a, the hot air flow in the first cavity 11 transfers a high temperature to the outer surface 25 of the heat dissipation air passage 2a, the heat from the outer surface 25 is transferred to the inner cavity 26, and the cold air flow in the second cavity 12 flows through the inner cavity 26 of the heat dissipation air passage 2a and cools the inner cavity 26, thereby realizing the cooling of the air flow in the first cavity 11, i.e. realizing the cooling of the heating device 4 in the first cavity 11.

Compared to the heat exchange plate in the conventional technology, the heat exchange area is increased with the heat dissipation air passage 2a. Moreover, the heat dissipation air passage 2a is arranged in the first cavity 11, and the inner cavity 26 of the heat dissipation air passage 2a is in communication with the second cavity 12, and thus the heat dissipation air passage 2a is designed in an embedded manner. Compared to the heat exchange plate in the conventional technology, the length of the heat dissipation air passage 2a is greater, further increasing the heat exchange area. Therefore, the heat exchange area is increased effectively with the heat dissipation air passage 2a, thereby improving the heat dissipation capacity and the heat dissipation effect.

It should be noted that under a same volume of the case 1, the heat dissipation air passage 2a according to the sixth embodiment can be applied to a power electronic apparatus with a high power level, a high power density, and a high heat flux, which is conducive to efficient heat dissipation and compact structure. Of course, alternatively, the heat dissipation air passage 2a according to the sixth embodiment may be applied to a power electronic apparatus with a low power level, a low power density, and a low heat flux. The application of the heat dissipation air passage 2a is not limited in the sixth embodiment.

Since the heat dissipation capacity and the heat dissipation effect are improved with the heat dissipation air passage 2a according to the sixth embodiment, it can be applied to a situation with a high ambient temperature. Specifically, in a case of a high ambient temperature, the above heat dissipation air passage 2a can also solve the problem of damages to the power electronic apparatus or a power reduction of the power electronic apparatus caused by excessive heat in the first cavity 11. The above heat dissipation air passage 2a can ensure the normal operation of the power electronic apparatus at a high environmental temperature.

In some embodiments, in order to improve the heat dissipation capacity, a first air cooling heat exchange structure and/or a liquid cooling heat exchange structure are provided in the inner cavity 26 of the heat dissipation air passage 2a.

As shown in FIG 13, the first air cooling heat exchange structure includes heat exchange fins 23. Usually, there are multiple heat exchange fins 23, and the air flow flows through a gap between two adjacent ones of the heat exchange fins 23. The number and the type of the heat exchange fins 23 are selected according to actual needs, which are not limited in the embodiment.

In some embodiments, the first air cooling heat exchange structure includes an air cooling heat exchange tube. The number and the distribution of the air cooling heat exchange tube are selected according to actual needs, which are not limited in the embodiment.

Of course, alternatively, the first air cooling heat exchange structure may include a heat exchange fin 23 and an air cooling heat exchange tube, and the specific form of the first air cooling heat exchange structure is not limited in the embodiment.

In some embodiments, the liquid cooling heat exchange structure includes a liquid cooling heat exchange tube and/or a liquid cooling heat exchange plate. The specific structure, the number, and the distribution of the liquid cooling heat exchange tube, as well as the specific structure, number, and distribution of the liquid cooling heat exchange plate, are selected according to actual needs, which are not limited in the embodiment.

In some embodiments, in order to improve the heat dissipation capacity, a second air cooling heat exchange structure may further be arranged on the outer surface 25 of the heat dissipation air passage 2a.

As shown in FIG 12, the second air cooling heat exchange structure includes heat exchange grooves 24. Other air cooling heat exchange structures, such as heat exchange protrusions, except for the heat exchange grooves 24, may be arranged on the outer surface 25 of the heat dissipation air passage 2a, which are not limited in the sixth embodiment.

In some embodiments, in order to accelerate the flow of air, the air flow in the second cavity 12 may be selected to flow through the inner cavity 26 of the heat dissipation air passage 2a under the action of the second fan 5, and the air flow in the first cavity 11 may be selected to flow through the outer surface 25 of the heat dissipation air passage 2a under the action of the first fan 3.

Reference may be made to the first embodiment for the distribution and protection levels of the first fan 3 and the second fan 5, which are not repeated here.

### Seventh embodiment

Based on the heat dissipation air passage according to the sixth embodiment, a power electronic apparatus is provided according to the seventh embodiment. The power electronic apparatus includes: a heating device, a case having a first cavity and a second cavity, and the heat dissipation air passage according to the sixth embodiment.

Since the heat dissipation air passage according to the sixth embodiment has the above technical effects, and the power electronic apparatus according to the embodiment includes the heat dissipation air passage, the power electronic apparatus according to the embodiment also has the corresponding technical effects, which are not repeated here.

The power electronic apparatus may be a power converter or other apparatuses, which is not limited in the embodiment.

The above description of the disclosed embodiments enables those skilled in the art to implement or use the present application. Various modifications to the embodiments are apparent to those skilled in the art, and general principles defined herein can be implemented in other embodiments without departing from the spirit or scope of the present application. Therefore, the present application is not limited to the embodiments described herein, and conforms to the widest scope consistent with the principles and novel features disclosed herein.

## Claims

1. A heat exchange structure of a power electronic apparatus, comprising:
a case; and
at least one heat exchanger; wherein
a first cavity and a second cavity are arranged in the case, the first cavity is configured to accommodate a heating device, and the first cavity is a closed cavity; and
the at least one heat exchanger is arranged in the first cavity, and the at least one heat exchanger has a heat exchange air passage communicated with the second cavity.

2. The heat exchange structure of a power electronic apparatus according to claim 1, wherein a first air cooling heat exchange structure and/or a liquid cooling heat exchange structure are provided in the heat exchange air passage.

3. The heat exchange structure of a power electronic apparatus according to claim 2, wherein the first air cooling heat exchange structure comprises a heat exchange fin or an air cooling heat exchange tube, and the liquid cooling heat exchange structure comprises a liquid cooling heat exchange tube or a liquid cooling heat exchange plate.

4. The heat exchange structure of a power electronic apparatus according to claim 1, wherein a second air cooling heat exchange structure is provided on an outer surface of the at least one heat exchanger.

5. The heat exchange structure of a power electronic apparatus according to claim 1, wherein
the at least one heat exchanger comprises: a heat exchange housing, and connection ports communicated with two ends of the heat exchange housing respectively, and
the heat exchange air passage is formed by an inner cavity of each of the connection ports and an inner cavity of the heat exchange housing.

6. The heat exchange structure of a power electronic apparatus according to claim 5, wherein each of the connection ports has a first interface and a second interface; wherein
the first interface is in communication with the inner cavity of the heat exchange housing, and the second interface is in communication with the second cavity; and
an axis of the first interface is perpendicular to or inclined relative to an axis of the second interface, and a length direction of the heat exchange housing is parallel to the axis of the first interface.

7. The heat exchange structure of a power electronic apparatus according to claim 5, wherein a first air cooling heat exchange structure is provided in the heat exchange housing and/or at least one of the connection ports; or, a liquid cooling heat exchange structure is provided in the heat exchange housing and/or at least one of the connection ports.

8. The heat exchange structure of a power electronic apparatus according to claim 1, wherein the first cavity comprises an inner mounting wall for arranging the heating device, and the at least one heat exchanger is arranged on the inner mounting wall.

9. The heat exchange structure of a power electronic apparatus according to claim 1, wherein the at least one heat exchanger is arranged close to an edge of the first cavity.

10. The heat exchange structure of a power electronic apparatus according to any one of claims 1 to 9, further comprising: at least one first fan, and/or at least one second fan;
wherein the at least one first fan is arranged in the first cavity, and the at least one second fan is arranged in the second cavity.

11. A power electronic apparatus, comprising: a heating device and the heat exchange structure of a power electronic apparatus according to any one of claims 1 to 10.

12. A heat dissipation air passage, applied to a power electronic apparatus, wherein the heat dissipation air passage comprises:
an inner cavity for an air flow in a second cavity of a case to flow through; and
an outer surface for an air flow in a first cavity of the case to flow through; wherein
the first cavity is a closed cavity and is configured to accommodate a heating device.

13. The heat dissipation air passage according to claim 12, wherein a first air cooling heat exchange structure and/or a liquid cooling heat exchange structure are provided in the inner cavity of the heat dissipation air passage.

14. The heat dissipation air passage according to claim 12, wherein a second air cooling heat exchange structure is provided on the outer surface of the heat dissipation air passage.

15. A power electronic apparatus, comprising: a heating device, a case having a first cavity and a second cavity, and the heat dissipation air passage according to any one of claims 12 to 14.
